# EUROPÄISCHE PATENTSCHRIFT

(11) **EP 3 235 020 B1**
(45) Veröffentlichungstag und Bekanntmachung des Hinweises auf die Patenterteilung: **27.11.2019**
(21) Anmeldenummer: 15825930.9
(22) Anmeldetag: 15.12.2015
(51) Int. Cl.: H01L 51/54

(54) **AMBIPOLARE HOSTMATERIALIEN FÜR OPTOELEKTRONISCHE BAUELEMENTE**
AMBIPOLAR HOST MATERIALS FOR OPTOELECTRONIC ELEMENTS
MATÉRIAUX HÔTES AMBIPOLAIRES POUR DES COMPOSANTS OPTOÉLECTRONIQUES

(30) Priorität: 15.12.2014 EP 14198008
(43) Veröffentlichungstag der Anmeldung: 25.10.2017
(73) Patentinhaber: cynora GmbH, 76646 Bruchsal (DE)
(72) Erfinder: LIAPTSIS, Georgios, 68161 Mannheim (DE)
(74) Vertreter: Hoppe, Georg Johannes
(86) Internationale Anmeldenummer: PCT/EP2015/079783
(87) Internationale Veröffentlichungsnummer: WO 2016/096851

(56) Entgegenhaltungen:
- CN-A- 103 951 813
- US-A1- 2011 303 877
- GEORGIOS LIAPTSIS ET AL: "Solution Processed Organic Double Light-Emitting Layer Diode Based on Cross-Linkable Small Molecular Systems", ANGEWANDTE CHEMIE INTERNATIONAL EDITION, Bd. 52, Nr. 36, 3. Juli 2013 (2013-07-03), Seiten 9563-9567, XP055189367, ISSN: 1433-7851, DOI: 10.1002/anie.201303031
- GEORGIOS LIAPTSIS ET AL: "Crosslinkable TAPC-Based Hole-Transport Materials for Solution-Processed Organic Light-Emitting Diodes with Reduced Efficiency Roll-Off", ADVANCED FUNCTIONAL MATERIALS, Bd. 23, Nr. 3, 21. Januar 2013 (2013-01-21), Seiten 359-365, XP055055178, ISSN: 1616-301X, DOI: 10.1002/adfm.201201197

## Beschreibung

Die Erfindung betrifft Moleküle der allgemeinen Formel 1, und deren Verwendung als vernetztes, flüssigprozessiertes Lochleiter- Elektronenblockiermaterial und/oder Hostmaterialien in organischen Licht emittierenden Dioden (OLEDs) und anderen opto-elektronischen Bauelementen.

### Einleitung

Organische elektronische Vorrichtungen werden immer häufiger in kommerziellen Produkten verwendet oder stehen kurz vor der Markteinführung. Als Beispiele für bereits kommerzielle Produkte seien organische oder polymere Leuchtdioden (OLEDs, PLEDs) in Anzeige- und Display-Vorrichtungen genannt. Organische Solarzellen (O-SCs), organische Feld-Effekt-Transistoren (O-FETs), organische Dünnfilmtransistoren (O-TFTs), organische Schaltelemente (O-ICs), organische optische Verstärker oder organische Laserdioden (O-Laser) sind in einem Forschungsstadium weit fortgeschritten und könnten in der Zukunft große Bedeutung erlangen. Der allgemeine Aufbau organischer Elektrolumineszenzvorrichtungen ist beispielsweise in der US 4539507, der US 5151629, der EP 0676461 und der WO 98/27136 beschrieben. Allerdings gibt es bei diesen Vorrichtungen noch Verbesserungsbedarf:
1. Die operative Lebensdauer ist insbesondere bei blauer bzw. grüner Emission immer noch gering, so dass bis dato nur einfache Anwendungen kommerziell realisiert werden konnten.
2. Die verwendeten Verbindungen sind teilweise nur schwer in gängigen organischen Lösemitteln löslich, was ihre Reinigung bei der Synthese, aber auch die Verarbeitung der Materialien aus Lösung und die Reinigung der Anlagen bei der Herstellung der elektronischen Vorrichtungen erschwert.
3. Die verwendeten Materialien gemäß dem Stand der Technik, weisen häufig eine niedrige Triplett-Energie auf. Dies führt bei Kombination mit Materialien, welche aus dem TriplettZustand emittieren, zu Quenching (Löschen) der Emission und so zu einer Verringerung der Effizienz.

Viele dieser elektronischen bzw. opto-elektronischen Vorrichtungen weisen unabhängig von dem jeweiligen Verwendungszweck folgenden allgemeinen Schichtaufbau auf, der für die jeweilige Anwendung angepasst werden kann:
(1) Substrat,
(2) Elektrode, die häufig metallisch oder anorganisch, aber auch aus organischen bzw. polymeren leitfähigen Materialien aufgebaut sein kann,
(3) gegebenenfalls eine oder mehrere Ladungsinjektionsschicht/en bzw. Pufferschicht/en zum Ausgleich von Unebenheiten der Elektrode, die häufig aus einem oder mehreren leitfähigen, dotierten Polymer/en ausgebildet ist/sind,
(4) mindestens eine Schicht eines organischen Halbleiters,
(5) gegebenenfalls eine oder mehrere weitere Ladungstransport- bzw. Ladungsinjektions- bzw. Ladungsblockierschicht/en,
(6) Gegenelektrode, bei der die unter (2) genannten Materialien eingesetzt werden,
(7) Verkapselung.

Eine Ausführungsform der Erfindung ist auf organische Leuchtdioden (OLED = Organic Light Emitting Diode) gerichtet, die bei Verwendung von polymeren Materialien oft auch als polymere Leuchtdioden (PLED = Polymer Light Emitting Diode) bezeichnet werden. Die obige Anordnung stellt den allgemeinen Aufbau einer optoelektronischen Vorrichtung dar, wobei verschiedene Schichten zusammengefasst werden können, so dass im einfachsten Fall eine Anordnung aus zwei Elektroden, zwischen denen sich eine organische Schicht befindet, besteht. Die organische Halbleiter-Schicht erfüllt in diesem Fall alle Funktionen, einschließlich der Emission von Licht.

Ein Problem, das sich in einem derartigen "Dreischichtsystem" ergibt, ist die fehlende Steuerung der Ladungstrennung oder die fehlende Möglichkeit, die einzelnen Bestandteile in unterschiedliche Schichten bezüglich ihrer Eigenschaften zu optimieren, wie es beispielsweise bei SMOLEDs ("small-molecule OLEDs") durch einen mehrschichtigen Aufbau einfach gelöst ist. Eine "small molecule OLED" besteht beispielsweise aus einer oder mehreren organischen Lochinjektionsschichten, Lochtransportschichten, Elektronenblockierschichten, Emissionsschichten, Lochblockierschichten, Elektronentransportschichten und Elektroneninjektionsschichten sowie einer Anode und einer Kathode, wobei sich das ganze System gewöhnlich auf einem Glassubstrat befindet. Ein Vorteil einer solchen Mehrlagenstruktur besteht darin, dass verschiedene Funktionen der Ladungsinjektion, des Ladungstransports und der Emission in die verschiedenen Schichten aufgeteilt und somit die Eigenschaften der jeweiligen Schichten separat modifiziert werden können.

Typische Lochtransportmaterialien in SMOLEDs sind beispielsweise Di- und Triarylamine, Thiophene, Furane oder Carbazole, wie sie auch in Photoleiteranwendungen untersucht und verwendet werden. Metallchelate, konjugierte aromatische Kohlenwasserstoffe, Oxadiazole, Imidazole, Triazine, Pyrimidine, Pyrazine, Pyridazine, Phenanthroline, Ketone oder Phosphinoxide werden gewöhnlich für die Emissions- und Elektronentransport-Schichten in SMOLEDs verwendet. Die Verbindungen, welche in einer SMOLED verwendet werden, können häufig durch Sublimationen gereinigt werden und stehen somit in Reinheiten größer als 99 Prozent zur Verfügung.

Das Aufbringen der Schichten in SMOLED-Vorrichtungen erfolgt gewöhnlich durch Aufdampfen in einer Vakuumkammer. Dieses Verfahren ist jedoch aufwändig und somit teuer und insbesondere für große Moleküle, wie beispielsweise Polymere, ungeeignet.

Ein Vorteil, den elektronische Vorrichtungen, welche auf löslichen Halbleitern basieren, besitzen, ist, dass diese aus Lösung hergestellt werden können, was mit geringerem technischen und Kostenaufwand verbunden ist als Vakuumprozesse, wie sie im Allgemeinen für niedermolekulare Verbindungen durchgeführt werden. So können beispielsweise einfarbige elektrolumineszierende Vorrichtungen vergleichsweise einfach erzeugt werden, indem die Materialien durch Flächenbeschichtung aus Lösung verarbeitet werden. Die Herstellung einer mehrschichtigen organischen Struktur durch Beschichtung aus Lösung erfordert jedoch, dass das Lösungsmittel mit der jeweils vorhergehenden Schicht inkompatibel ist, um diese nicht wieder anzulösen, zu quellen oder gar zu zerstören. Die Wahl des Lösungsmittels erweist sich jedoch als schwierig, da die eingesetzten organischen Verbindungen gewöhnlich ähnliche Eigenschaften, insbesondere ähnliche Lösungseigenschaften, besitzen. Bereits die Aufbringung einer ersten Polymerschicht auf beispielsweise eine Indium-Zinnoxid-Schicht bereitet meist schon Probleme, da keine ausreichende Haftung der Polymerschicht auf dem Indium-Zinn-Oxid (ITO) gewährleistet werden kann. Darum werden ITO-Substrate aufwendig gereinigt und mit einem UV/Ozon-Plasma oberflächenaktiviert, um eine bessere Haftung und eine bessere Benetzung der nachfolgenden organischen Schichten zu gewährleisten. Die erste aufgebrachte organische Schicht ist dabei gewöhnlich die sogenannte Pufferschicht, die aus einer wässrigen Dispersion (z. B. Poly-3,4-ethylendioxythiophen/Polystyrolsulfonat (PEDOT/PSS)) abgeschieden wird. Die erhaltene Schicht von Poly-3,4-ethylendioxythiophen/Polystyrolsulfonat (PEDOT/PSS) gleicht Unebenheiten der ITO-Schicht aus und sorgt für gute Lochinjektion in die nachfolgenden organischen Schichten. Ohne die Vorbehandlung des ITO würde die PEDOT-Schicht nicht haften, die direkte Abscheidung weniger polarer organischer Schichten auf ITO aus Lösung ist gar nicht möglich. Bei einer Aufbringung weiterer Schichten aus Lösung wird die erste Polymerschicht auf dem ITO wieder angelöst oder gar abgewaschen und dadurch zerstört.

Entsprechend sind polymere OLEDs aus dem Stand der Technik gewöhnlich auf der Anodenseite nur aus einer einschichtigen oder höchstens zweischichtigen organischen Struktur aufgebaut, wobei auf das PEDOT entweder direkt das emittierende Polymer folgt oder eine für die Lochinjektion und den Lochtransport verwendete Zwischenschicht. Vorteilhaft bei den polymeren OLEDs wäre jedoch auch eine Mehrschichtstruktur.

Herzstück solcher Bauteile ist die Emitterschicht, welche typischerweise zwischen einer Anode und einer Kathode angeordnet ist und die in der Regel aus einem Hostmaterial besteht, in welches die emittierenden Moleküle eingebettet sind. Weitere Schichten, wie die Lochinjektionsschicht, die Lochtransportschicht, die Elektronenleitschicht und die Zwischenschicht bewirken im Allgemeinen eine dramatisch verbesserte Effizienz der Bauteile. Bei Anlegen eines Stroms/einer Spannung treffen sich negative Ladungsträger (Elektronen) und positive Ladungsträger (Löcher), die zu sogenannten Exzitonen (= angeregte Zustände) rekombinieren. Die in den Exzitonen enthaltene Energie kann von den entsprechenden Emittern in Form von Licht abgegeben werden, wobei man in diesem Fall von Elektrolumineszenz spricht. Einen Überblick über die Funktion von OLEDs findet sich beispielsweise bei H. Yersin, Top. Curr. Chem. 2004, 241, 1 und H. Yersin, "Highly Efficient OLEDs with Phosphorescent Materials"; Wiley-VCH, Weinheim, Germany, 2008.

Für organische Elektrolumineszenzvorrichtungen besteht Bedarf an verbesserten Materialien, die thermisch stabil sind, die in organischen elektronischen Vorrichtungen zu guten Effizienzen und gleichzeitig zu hohen Lebensdauern führen, die bei der Herstellung und beim Betrieb der Vorrichtung zu reproduzierbaren Ergebnissen führen und die synthetisch einfach zugänglich sind. Auch bei Loch- und Elektronentransportmaterialien sind weitere Verbesserungen erforderlich.

Die CN 103 951 813 A beschreibt 9-Aryl substituierte Flourenyl-konjugierte Polyelektrolyte, sowie deren Herstellung und Verwendung.

Aus der US 2011/303877 A1 sind quervernetzbare und quervernetzte Polymere bekannt sowie Verfahren zu deren Herstellung und Verwendung.

Georgios Liaptsis et al., "Solution Processed Organic Double Light-Emitting Layer Diode Based on Cross-Linkable Small Molecular Systems", Angewandte Chemie International Edition, Band 52, Nr. 36, Seiten 9563-9657 beschreibt quervernetzbare kleine molekulare Systeme zur Herstellung lichtemittierender Dioden.

Georgios Liaptsis et al., "Crosslinkable TAPC-Based Hole-Transport Materials for Solution-Processed Organic Light-Emitting Diodes with Reduced Efficiency Roll-Off", Advanced Functional Materials, Band 23, Nr. 3, Seiten 359-365 betrifft quervernetzbare TAPC-basierte Lochtransportmaterialien für flüssigprozessierte organische lichtemittierende Dioden.

### Beschreibung

Die vorliegende Erfindung betrifft in einem Aspekt organische Moleküle der Formel 1, deren Struktur weiter unten angegeben ist, welche auch aus Lösung prozessiert werden können und sehr gute Filmbildungseigenschaften aufweisen. Ferner werden die Grenzorbitale durch Einführung elektronenziehender oder schiebender Gruppen den entsprechenden Anforderungen im Bauteil selbst sehr genau angepasst (Injektion, Transport, Sperrung, Wirt), wobei die energetische Lages des T1-Niveau des entsprechenden Materials von der chemischen Modifikation unberührt bleibt und einen eventuellen Energierücktransfer eines umgebenden Materials von dessen Triplettzustands vorbeugt.

Die Verwendung von polymerisierbaren Gruppen, die über eine löslichkeitsvermittelnde Verbindung an die Triarylamino-fluoren Grundstruktur verknüpft sind, lässt den zuvor aus Lösung hergestellten Film in ein unlösliches Netzwerk überführen. Hierdurch kann eine weitere Schicht aus Lösung auf das bereits beschichtete Substrat aufgebracht werden, ohne eine Vermischung an der Grenzfläche und ohne ein Anlösen der zuvor abgeschiedenen Schicht hervorzurufen. Durch Substituenten am Fluorenanker, einem Triarylamino-fluoren-Grundkörper, wird die Langlebigkeit des Grundgerüstes im elektrischen Betrieb erhöht. Die Multifunktionalität des Materials erlaubt die Einsparung mehrerer Schichten im Bauteil.

Durch die Erfindung wird die Reinheit der erfindungsgemäßen kleinen Moleküle mit einem kosteneffizienten lösemittelbasierten Herstellungsverfahren realisiert. Dies erlaubt die Herstellung modernster Mehrschichtbauteile mit geringerem Materialverlust im Vgl. zu CVD bzw. PVD Herstellungstechniken sowie gegebenenfalls die Reduzierung der Zahl an funktionellen Schichten in einem OLED-Bauteil.

Die Erfindung betrifft in einem Aspekt organische Moleküle der allgemeinen Formel 1 mit einem Triarylamino-fluoren Grundkörper 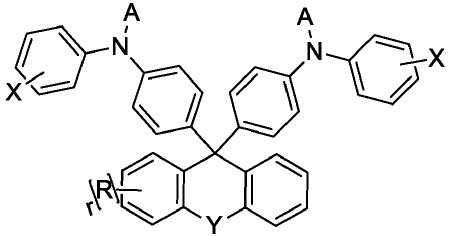 mit 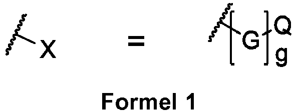 wobei gilt
Y ist eine kovalente Einfachbindung oder eine bivalente Brücke ausgewählt aus O, S, S=O, SO₂, Se, Se=O, SeO₂, C(R³)₂, C=NR³, C=C(R³)₂, Si(R³)₂, N(R³), P(R³), P(=O)R³ oder B(R³).
R ist bei jedem Auftreten gleich oder verschieden Wasserstoff, Deuterium, Halogen, Sauerstoff, eine Alkylgruppe (unverzweigt, verzweigt oder zyklisch), eine Alkoxygruppe (unverzweigt, verzweigt oder zyklisch), eine Alkenylgruppe (unverzweigt, verzweigt oder zyklisch), oder eine Aryl- oder Heteroarylgruppe mit 5 bis 40 Ringatomen, die jeweils durch einen oder mehrere Reste R⁴ substituiert sein kann, oder ein aromatisches oder heteroaromatisches Ringsystem mit 5 bis 60 aromatischen Ringatomen, das jeweils durch einen oder mehrere Reste R⁴ substituiert sein kann, oder eine Aryloxy- oder Heteroaryloxygruppe mit 5 bis 40 aromatischen Ringatomen, die durch einen oder mehrere R⁴ substituiert sein kann, oder eine Aralkyl- oder Heteroaralkylgruppe mit 5 bis 40 aromatischen Ringatomen, die durch einen oder mehrere R⁴ substituiert sein kann, oder eine Kombination dieser Systeme; dabei können zwei oder mehrere Substituenten R auch miteinander, zusammen mit den Atomen, an die sie gebunden sind, ein mono- oder polycylisches aliphatisches oder aromatisches Ringsystem bilden.
   R³ ist bei jedem Auftreten gleich oder verschieden H, D, OR⁵, SR⁵ oder C(R⁵)₃;
   R⁴ ist bei jedem Auftreten gleich oder verschieden H, D, OR⁵, SR⁵ oder C(R⁵)₃;
   R⁵ ist bei jedem Auftreten gleich oder verschieden Wasserstoff, eine Alkylgruppe oder eine Arylgruppe.
r ist zwischen 0 und 8.

Bei dem Substituenten bestehend aus einer verzweigten oder linearen Kette mit g Gliedern G sowie einem Vernetzungsrest Q handelt es sich um einen sogenannten Prozessierungsrest.

Die Zahl an Gliedern in der Kettenverbindung zwischen Q und der Anknüpfungsposition an das Triarylamino-fluoren Gerüst liegt zwischen 3 und 10, insbesondere 5 und 9, und bevorzugt 6 und 8.

Die Glieder G ist bei jedem Auftreten gleich oder verschieden eine Alkylgruppe (unverzweigt, verzweigt oder zyklisch), eine Alkoxygruppe (unverzweigt, verzweigt oder zyklisch), eine Alkenylgruppe (unverzweigt, verzweigt oder zyklisch), oder eine Aryl- oder Heteroarylgruppe mit 5 bis 40 Ringatomen, die jeweils durch einen oder mehrere Reste R⁴ substituiert sein kann, oder ein aromatisches oder heteroaromatisches Ringsystem mit 5 bis 60 aromatischen Ringatomen, das jeweils durch einen oder mehrere Reste R⁴ substituiert sein kann, oder eine Aryloxy- oder Heteroaryloxygruppe mit 5 bis 40 aromatischen Ringatomen, die durch einen oder mehrere R⁴ substituiert sein kann, oder eine Aralkyl- oder Heteroaralkylgruppe mit 5 bis 40 aromatischen Ringatomen, die durch einen oder mehrere R⁴ substituiert sein kann, oder eine Kombination dieser Systeme;
R³ ist bei jedem Auftreten gleich oder verschieden H, D, OR⁵, SR⁵ oder C(R⁵)₃;
R⁴ ist bei jedem Auftreten gleich oder verschieden H, D, OR⁵, SR⁵ oder C(R⁵)₃;
R⁵ ist bei jedem Auftreten gleich oder verschieden Wasserstoff, eine Alkylgruppe oder eine Arylgruppe;

Mindestens eines der Glieder G in der Kette ist in einer Ausführungsform ein Sauerstoffatom.

Als Vernetzungsreste Q eignen sich alle photochemisch oder thermisch vernetzbaren Gruppen. Derartige Gruppen sind dem Fachmann bekannt und werden beispielsweise in Zuniga, C. a.; Barlow, S.; Marder, S. R. Chem. Mater. 2011, 23, 658 beschrieben. Br stellt keine photochemisch oder thermisch vernetzbare Gruppe dar. Beispiele für mögliche Vernetzungsreste Q sind:

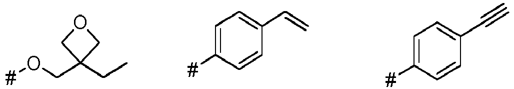

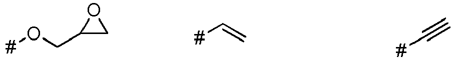

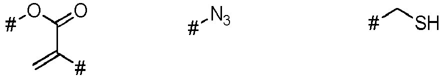

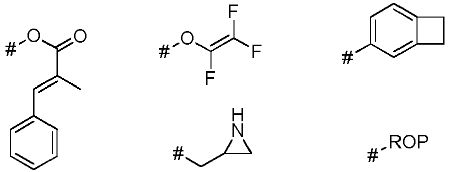

Die Anknüpfung an die Kette -[G]_{g}- erfolgt über #. Alle in den gezeigten Gruppen Q enthalten C-H-Bindungen können optional mit einem Rest R* funktionalisiert sein. Dieser ist bei jedem Auftreten gleich oder verschieden Wasserstoff, Halogen, Deuterium, Gruppen, die über Stickstoff (-NR₂²) oder Sauerstoff- (-OR²) gebunden sind, Alkyl- (unverzweigt, verzweigt oder zyklisch), Heteroalkyl-, Aryl-, Heteroaryl-, Alkenyl-, Alkinyl-Gruppen oder substituierte Alkyl-(unverzweigt, verzweigt oder zyklisch), Heteroalkyl-, Aryl-, Heteroaryl- und Alkenyl-Gruppen mit Substituenten wie Halogene oder Deuterium, Alkylgruppen (unverzweigt, verzweigt oder zyklisch). ROP = Gruppe, die sich zur Ringöffnenden Polymerisation eignet. R² ist bei jedem Auftreten gleich oder verschieden H, eine geradkettige, verzweigte oder cyclische Alkyl- oder Alkoxyalkylgruppe mit 1 bis 20 C-Atomen, eine Aryl- oder Heteroaryl-Gruppe mit 4 bis 20 aromatischen Ringatomen oder eine Alkenylgruppe mit 2 bis 10 C-Atomen, bei denen ein oder mehrere Wasserstoffatome durch Halogen oder CN ersetzt sein können und ein oder mehrere nicht benachbarte C-Atome durch -O-, -S-, -CO-, -COO- oder -O-CO- ersetzt sein können; Z ist bei jedem Auftreten gleich oder verschieden eine bivalente Gruppe -(CR⁶R⁷)ₙ-, bei der auch ein oder mehrere nicht benachbarte C-Atome durch -O-, -S-, -CO-, -COO- oder -O-CO- ersetzt sein können, oder eine bivalente Aryl- oder N-, S- und/oder O-Heteroarylgruppe mit 4 bis 40 C-Atomen, die auch mit ein oder mehreren Resten R⁶ substituiert sein kann; R⁶, R⁷ ist bei jedem Auftreten gleich oder verschieden H, eine geradkettige, verzweigte oder cyclische Alkyl-, Alkoxy-, Alkoxyalkyl- oder Thioalkoxy- Gruppe mit 1 bis 20 C-Atomen, eine Aryl- oder Heteroaryl-Gruppe mit 4 bis 20 aromatischen Ringatomen oder eine Alkenyl-Gruppe mit 2 bis 10 C- Atomen, bei denen ein oder mehrere Wasserstoffatome auch durch Halogen oder CN ersetzt sein können

In einer Ausführungsform handelt es sich bei der Vernetzungsreaktion um eine Homopolymerisation.

Der Steuerrest A der Formel 1 ist gemäß Unterformel 2

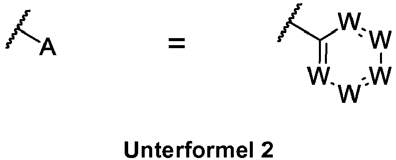

Der Steuerrest A besteht entsprechend aus einem sechsgliedrigen Ring mit einem Ringglied C und fünf Ringgliedern W, die unabhängig ausgewählt sind aus N, C-H, C-Ak oder C-Do. Ak steht für Akzeptorgruppe und Do für Donorgruppe, wobei die Ringglieder N, C-H C-Ak und C-Do beliebig kombiniert werden können. Gängige Akzeptor und Donorgruppen sind dem Fachmann bekannt.

Beispiele für Akzeptorgruppen sind -(C=O)R, -F, -CF₃, und -CN; Beispiele für Donorgruppen sind -OR, -NR₂ und -CR₃, wobei R wie bei Formel 1 definiert ist. Beispielhaft werden die folgenden Gruppen angegeben:

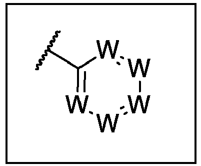

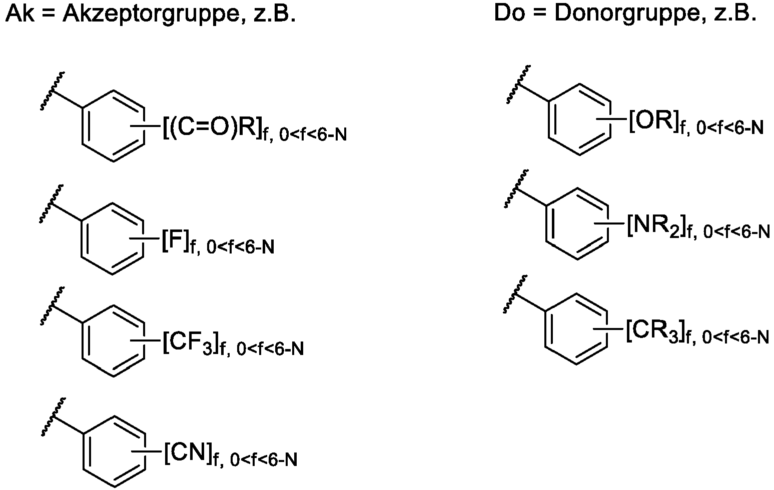

In einer weiteren Ausführungsform werden Vernetzungsgruppen Q verwendet, die aus der Familie der Oxetane stammen und eine Struktur gemäß der Unterformeln 3 oder 4 aufweisen, 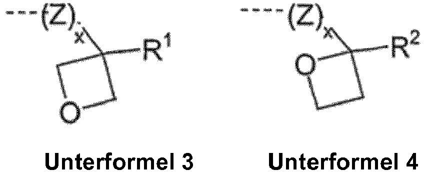 wobei für die verwendeten Symbole und Indizes gilt:
R¹ ist bei jedem Auftreten gleich oder verschieden H, eine geradkettige, verzweigte oder cyclische Alkyl-, Alkoxyalkyl-, Alkoxy- oder Thioalkoxy- Gruppe mit 1 bis 20 C-Atomen, eine Aryl- oder Heteroaryl-Gruppe mit 4 bis 20 aromatischen Ringatomen oder eine Alkenylgruppe mit 2 bis 10 C-Atomen, bei denen ein oder mehrere Wasserstoffatome durch Halogen oder CN ersetzt sein können und ein oder mehrere nicht benachbarte C-Atome durch -O-, -S-, -CO-, -COO- oder -O-CO- ersetzt sein können; R² ist bei jedem Auftreten gleich oder verschieden H, eine geradkettige, verzweigte oder cyclische Alkyl- oder Alkoxyalkylgruppe mit 1 bis 20 C-Atomen, eine Aryl- oder Heteroaryl-Gruppe mit 4 bis 20 aromatischen Ringatomen oder eine Alkenylgruppe mit 2 bis 10 C-Atomen, bei denen ein oder mehrere Wasserstoffatome durch Halogen oder CN ersetzt sein können und ein oder mehrere nicht benachbarte C-Atome durch -O-, -S-, -CO-, -COO- oder -O-CO- ersetzt sein können; Z ist bei jedem Auftreten gleich oder verschieden eine bivalente Gruppe -(CR⁶R⁷)ₙ-, bei der auch ein oder mehrere nicht benachbarte C-Atome durch -O-, -S-, -CO-, -COO- oder -O-CO- ersetzt sein können, oder eine bivalente Aryl- oder N-, S- und/oder O-Heteroarylgruppe mit 4 bis 40 C-Atomen, die auch mit ein oder mehreren Resten R⁶ substituiert sein kann; R⁶, R⁷ ist bei jedem Auftreten gleich oder verschieden H, eine geradkettige, verzweigte oder cyclische Alkyl-, Alkoxy-, Alkoxyalkyl- oder Thioalkoxy- Gruppe mit 1 bis 20 C-Atomen, eine Aryl- oder Heteroaryl-Gruppe mit 4 bis 20 aromatischen Ringatomen oder eine Alkenyl-Gruppe mit 2 bis 10 C- Atomen, bei denen ein oder mehrere Wasserstoffatome auch durch Halogen oder CN ersetzt sein können; dabei können auch Reste R⁶ bzw. R⁷ miteinander bzw. mit R¹ oder R² ein Ringsystem bilden; n ist bei jedem Auftreten gleich oder verschieden eine ganze Zahl zwischen 0 und 30, vorzugsweise zwischen 1 und 20, insbesondere zwischen 2 und 12, x ist bei jedem Auftreten gleich oder verschieden 0, 1 , 2, 3, 4 oder 5, insbesondere 1 , 2 oder 3.

Durch die gestrichelte Bindung in den Unterformeln 3 bis 6 wird die Anknüpfung an die Kette (G)g angedeutet. Sie ist hier nicht als Methylgruppe zu verstehen.

Die Gruppe X der erfindungsgemäßen organischen Moleküle der Formel 1 vereint verschiedene Eigenschaften. Zum einen ist die photochemisch oder thermisch vernetzbare Gruppe Q enthalten. Zum anderen ist der Teil G enthalten, welcher löslichkeitsverbessernde Eigenschaften in organischen Lösungsmitteln sowie günstige Filmbildungseigenschaften bewirkt. Diese ermöglichen die Anwendung von Prozessierungsverfahren wie InkJet Printing, Roll-to-Roll-Verfahren oder Slot-Die-Coating bei der Herstellung optoelektronischer Bauteile.

Bei der Polymerisation der erfindungsgemäßen Moleküle entstehen nicht-konjugierte Polymere. Diese haben größere Bandlücken und höhere S₁-, T₁- und LUMO-Lagen als konjugierte Polymere, was sich insbesondere für den Einsatz in blau emittierenden Elektrolumineszenzvorrichtungen als günstig erweist.

In einer bevorzugten Ausführungsform weisen die erfindungsgemäßen organischen Moleküle eine Struktur der Formel 1a auf 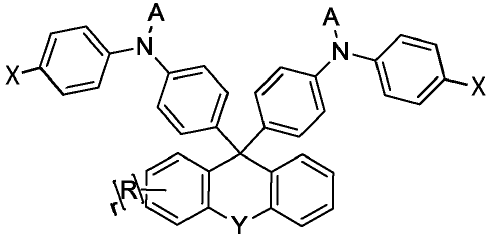 mit 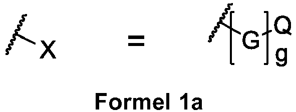 wobei A ein Steuerrest gemäß Unterformel 2a ist 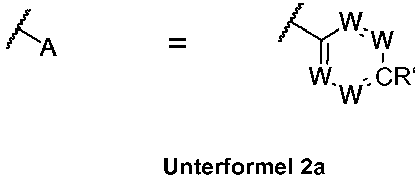 mit R' = Ak oder Do
und wobei im Übrigen die für die Formel 1 und die Unterformel 2 angegebenen Definitionen gelten.

Überraschend wurde gefunden, dass die durch Formel 1 bestimmten Verbindungen zu deutlichen Verbesserungen der organischen Elektrolumineszenzvorrichtung führen, insbesondere hinsichtlich der Lebensdauer, der Effizienz und der Betriebsspannung. Dies gilt insbesondere auch für grün und blau phosphoreszierende Elektrolumineszenzvorrichtungen, vor allem bei Einsatz der erfindungsgemäßen Verbindungen als Lochtransport-, Elektronentransport- und Excitonenblockermaterial, sowie als Matrixmaterial. Diese Materialien sowie organische Elektrolumineszenzvorrichtungen, welche derartige Verbindungen enthalten, sind daher der Gegenstand der vorliegenden Erfindung.

Außerdem ermöglichen die erfindungsgemäßen Verbindungen die Anwendung von Vernetzungsverfahren durch photochemische oder thermische Vernetzung, ohne die die Herstellung von effizienten, langlebigen flüssig-prozessierten OLEDs nicht möglich sein wird. Dies gilt dann, wenn durch chemische Modifikation am Triarylamingrundkörper der erfindungsgemäßen Moleküle mit einer Struktur der Formel 1 die Eigenschaften gezielt modifiziert werden. Dies ist theoretisch an allen drei an den Stickstoff angebundenen ArylResten möglich, aus praktischen und synthetischen Erwägungen jedoch nur für zwei der drei Reste sinnvoll, da über den dritten Arylrest als Spacer die Anknüpfung an das in Triarylamino-fluoren enthaltene Fluoren-Gerüst erfolgt. Überraschend wurde dabei gefunden, dass durch die Aufteilung der beiden wünschenswerten Funktionen der Quervernetzung sowie der Einstellung der Grenzorbitale auf unterschiedliche Arylreste des Triarylamin-Rests in der Triarylamino-fluoren-Grundstruktur beide Aufgaben besonders gut und effizient erfüllen lassen. Das höchste besetzte Molekülorbital sitzt bei dieser Triarylamino-fluoren-Grundstruktur auf einem der beiden Triarylamine, dass durch die gezielte chemische Modifikation mit elektronenziehenden oder schiebenden Gruppen (W) am Aromatischen System entsprechend elektronenreicher oder elektronenärmer wird, was die energetische der Grenzorbitale Lage gegen Vakuum entsprechend verschiebt. Durch Verwendung von polymerisierbaren Gruppen können entsprechende thermisch, radikalisch, ionisch oder photochemisch geartetet Reaktionen zur Homo- bzw. zur Heteropolymerisation bei entsprechender Behandlung führen, was die Löslichkeit des zuvor abgeschiedenen Materials drastisch sinkt. Die Eignung für die lösungsmittelbasierte Prozessierung wird stark erhöht, da einerseits die Löslichkeit ansteigt und andererseits die Tendenz zur Kristallisation nach oder während der Prozessierung, eines bei der Herstellung von OLEDs unterwünschten Vorgangs, effektiv unterbunden wird. Die Erfindung beruht auf zuvor nicht beschriebenen Molekülen. Die erfindungsgemäßen organischen Moleküle weisen zudem eine hohe Triplett-Energie auf. Diese ist vor allem für die Kombination mit blauen Emittern vorteilhaft.

Durch die vorliegende Erfindung werden neue unipolare Lochtransportmaterialien, sowie bei entsprechender Modifikation ambipolaren Hostmaterialien, die durch geschickte Wahl des Substitutionsmusters über verbesserte Eigenschaften bezüglich Effizienz, Lebensdauer und Betriebsspannung verfügen, bereitgestellt.

Die Erfindung betrifft in einem Aspekt die Darstellung erfindungsgemäßer Moleküle mit einer Struktur der Formel 1. Die erfindungsgemäßen Moleküle sind über folgende allgemeine Syntheseroute erhältlich, beispielsweise durch Ullmann-Kupplung oder Buchwald-Hartwig-Aminierungen:

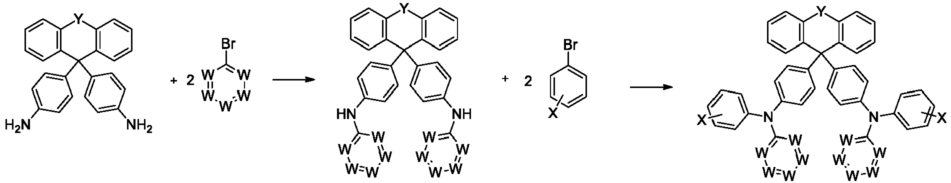

Ein weiterer Gegenstand der vorliegenden Verbindung ist die Verwendung eines organischen Moleküls der hierin beschriebenen Art in einer emittierenden Schicht als Matrixmaterial (Hostmaterial) für lumineszierende Emitter und/oder als Elektronentransportmaterial und/oder als Lochinjektionsmaterial und/oder als Lochblockiermaterial in einem optoelektronischen Bauelement.

In einer Ausführungsform der Erfindung wird das organische Molekül der hierin beschriebenen Art in einer emittierenden Schicht eines optoelektronischen Bauelementes, insbesondere in Mischung mit mindestens einer weiteren Verbindung verwendet. Das organische Molekül der hierin beschriebenen Art ist in der Mischung insbesondere das Matrixmaterial.

In einer Ausführungsform der Erfindung wird ein organisches Moleküle der hierin beschriebenen Art entsprechend als Matrixmaterial für lumineszierende Emitter in einem optoelektronischen Bauelement eingesetzt.

Ein optoelektronisches Bauelement gemäß der vorliegenden Erfindung ist in einer Ausführungsform ausgewählt aus der Gruppe bestehend aus:
- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- organischen Solarzellen,
- Organischen Feldeffekttransistoren,
- Organischen Lasern
- Down-Konversions-Elementen und
- Up-Konversions-Elementen.

Ein weiterer Erfindungsaspekt betrifft Mischungen, enthaltend mindestens ein organisches Molekül der hierin beschriebenen Art und mindestens einen lumineszierenden Emitter.

In einem weiteren Aspekt betrifft die Erfindung Formulierungen enthaltend mindestens ein organisches Molekül der hierin beschriebenen Art oder eine hier beschriebene Mischung und mindestens ein Lösemittel.

In einer Ausführungsform beträgt der Anteil des organischen Materials als Matrixmaterial in optischen lichtemittierenden Bauelementen, insbesondere in OLEDs, zwischen 50 % und 99 %.

In einer weiteren Ausführungsform beträgt der Anteil des organischen Materials als CoHost (0-50%), um beispielsweise die Transporteigenschaften zu erhöhen, und/oder Sensibilisator, um die Effizienz des Energietransfers (trivial und/oder Förster und/oder Dexter) auf den Emitter in optischen lichtemittierenden Bauelementen, insbesondere in OLEDs, zu erhöhen.

In einem weiteren Aspekt betrifft die Erfindung ein optoelektronisches Bauelement aufweisend ein organisches Molekül der hierin beschriebenen Art. Hierbei enthält ein erfindungsgemäßes optoelektronisches Bauelement mindestens eine Schicht zwischen Anode und Kathode, die ein organisches Molekül der hierin beschriebenen Art beispielsweise als Matrixmaterial (Hostmaterial), CoHost, Sensitizer für lumineszierende Emitter und/oder als Elektronentransportmaterial und/oder als Lochinjektionsmaterial und/oder als Lochblockiermaterial enthält. Hierbei kann das optoelektronische Bauelement ausgewählt sein aus der Gruppe bestehend aus organischem lichtemittierendem Bauelement, organischer Diode, organischer Solarzelle, organischem Transistor, organischer Licht-emittierender Diode, Licht-emittierender elektrochemischer Zelle, organischem Feldeffekttransistor und organischem Laser.

In einem weiteren Aspekt betrifft die Erfindung ein Verfahren zur Herstellung eines optoelektronischen Bauelements, wobei ein organisches Molekül der hierin beschriebenen Art verwendet wird.

Teil eines derartigen Verfahrens kann das Aufbringen eines erfindungsgemäßen organischen Moleküls auf einen Träger sein. Das Aufbringen kann optional durch Verdampfung im Vakuum oder nass-chemisch erfolgen.

Die hierfür gängigen Verfahren sind dem Fachmann bekannt und können von ihm ohne Probleme auf optoelektronische Bauelemente enthaltend ein organisches Molekül der hierin beschriebenen Art angewandt werden.

Die erfindungsgemäßen organischen Moleküle weisen bei Verwendung in optoelektronischen Bauteilen folgende überraschende Vorteile gegenüber dem Stand der Technik auf: Die Ladungsträgermobilität im Bauteil, die Efiizienz, Stabilität und/oder die Lebensdauer der Bauteile wird im Vergleich zu Systemen gemäß dem Stand der Technik verbessert.

Im vorliegenden Anmeldetext und in den im Weiteren folgenden Beispielen wird in erster Linie auf die Verwendung der erfindungsgemäßen organischen Moleküle in OLEDs und den entsprechenden Displays und Beleuchtungselementen verwiesen. Trotzdem ist es dem Fachmann ohne erfinderisches Zutun möglich, die organischen Moleküle der hierin beschriebenen Art auch für weitere Verwendungen in anderen optoelektronischen Bauelementen einzusetzen.

Als Vorteile der erfindungsgemäßen Materialien lässt sich vor allem die exzellente Verarbeitbarkeit aufführen: Die erfindungsgemäßen organischen Moleküle stehen lösemittelbasierten Herstellungsprozessen (Lackschleudern, Siebdruck, Tintendruck, Schlitzguss, etc.) zur Verfügung, wobei das Material sehr gute Filmbildungseigenschaften aufweist. Die Grenzorbitale (HOMO und LUMO) sind durch chemische Modifikation verschiedenen Anforderungen angepasst (Ladungsträgerinjektion, Ladungstransport, Ladungssperrung, Excitonensperrung). Dadurch werden beispielsweise lochtransportierende Materialien möglich, die grüne bzw. blaue Triplettemission nicht quenchen, aber im Gegensatz zu dem sehr kleinen Triphenylamin bzw. Tritolylamin über gute Filmbildungseigenschaften und eine höhere Glastemperatur verfügen. Der gleiche Effekt lässt sich für Elektronenleiter anwenden, wo ähnliche Nachteile der Biphenylbrücke bzgl. ihrer Triplettenergie beobachtet wurden. Ebenso sind tiefblaue Emitter und Matrixmaterialien für Triplettemitter möglich.

Außerdem ist das Material multifunktional und verringert die notwendige Anzahl an Schichten im organischen Bauelement. Die Langzeitstabilität des Grundgerüstes wird durch Modifikation am Fluorenanker erhöht (Stabilisierung von Radikalen auf dem Fluorengerüst). So ist im Vergleich zu Triarylamino-fluoren Derivaten mit fluorenartiger Brücke bei TAPC Derivaten (TAPC = 4,4'-Cyclohexylidenebis[N,N-bis(4-methylphenyl)benzenamine]) eine Cyclohexylbrücke vorhanden, die eine Schwachstelle im Betrieb einer OLED darstellt und die Degradation unter elektrischer Spannung initiiert.

Die Reinheit kleiner Moleküle im Vergleich zu Polymeren, die sich häufig nur unzureichend aufreinigen und von Monomerverunreinigungen abtrennen lassen, wird nun mit der Lösemittel basierten Verarbeitungstechniken gepaart. Hierdurch werden die Herstellungskosten organischer Bauteile potentiell stark reduziert ohne auf Leuchteffizienz und Lebensdauer verzichten zu müssen.

Durch die nachfolgenden Beispiele wird die Erfindung erläutert, ohne sie dadurch einzuschränken.

### Beispiele

Allgemeine Synthesevorschrift mittels Buchwald-Hartwig-Aminierungen:
Alle Buchwald-Hartwig-Aminierungen wurden unter Schlenkbedingungen durchgeführt. Es wurden jeweils 1.0 eq Arylamin und 2.0 eq Bromaromat in trockenem Toluol (10 ml/mmol Amin) vorgelegt und mit 1.5 eq an Base pro reagierendes N*H* versetzt. Die zuvor angesetzten Katalysatorlösung, bestehend aus 0.01 eq Pd₂(dba)₃ und 0.016 eq P(*f*Bu)₃ pro reagierendes N*H* in Toluol wurde anschließend zur Reaktionsmischung gegeben. Diese wurden 2-24 h bei 80 °C gerührt. Die Aufarbeitung erfolgte durch quenchen des Katalysators mit Wasser, worauf 3x mit Ethylacetat extrahiert wurde. Die vereinigten organischen Phasen wurden im Vakuum vom Lösemittel befreit und anschließend mittels Säulenchromatographie gereinigt (Eluent bestehend aus Cyclohexan / Ethylacetat Mischungen, graduiert).

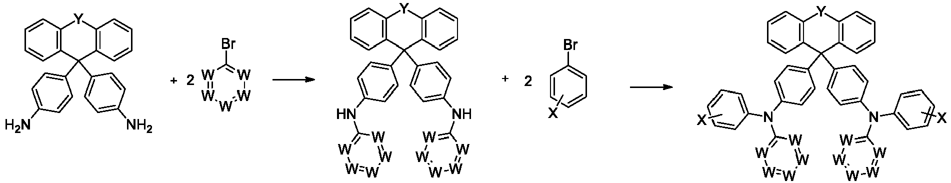

### Beispiel 1: Molekül 1

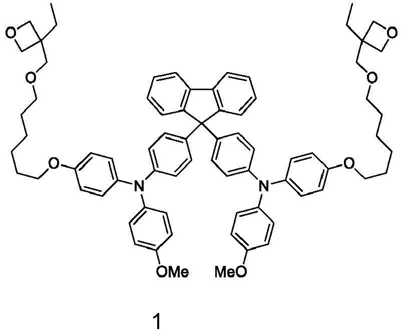

Die Einführung von A an das Bisanilin erfolgte in einer Ausbeute von 92 %. Die zweite Stufe, die Einführung von X erfolgte darauf in einer Ausbeute von 70 %.

### Beispiel 2: Molekül 2

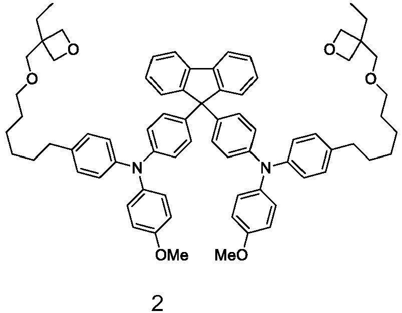

Die Einführung von A an das Bisanilin erfolgte in einer Ausbeute von 92 %. Die zweite Stufe, die Einführung von X erfolgte in einer Ausbeute von 80 %.

### Beispiel 3: Molekül 3

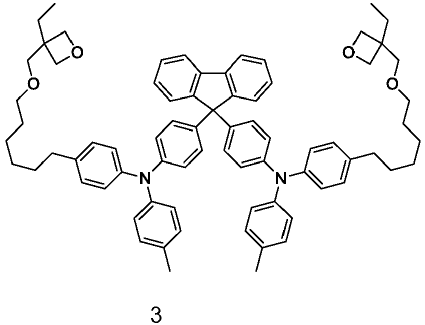

Die Einführung von A an das Bisanilin erfolgte in einer Ausbeute von 64 %. Die zweite Stufe, die Einführung von X erfolgte darauf in einer Ausbeute von 44 %.

### Beispiel 4: Molekül 4

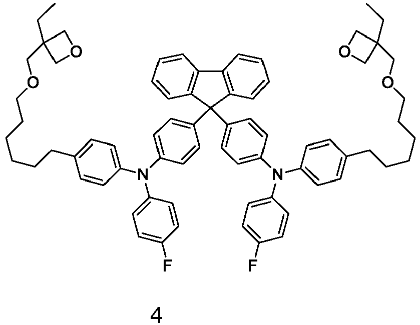

Die Einführung von A an das Bisanilin erfolgte in einer Ausbeute von 42 %. Die zweite Stufe, die Einführung von X erfolgte darauf in einer Ausbeute von 71 %.

### Beispiel 5: Molekül 5

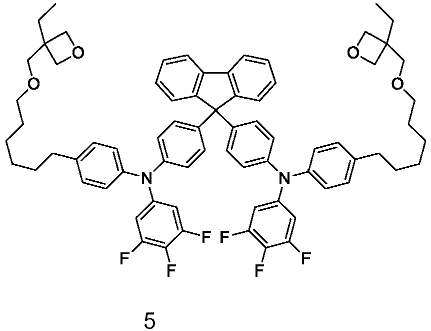

Die Einführung von A an das Bisanilin erfolgte in einer Ausbeute von 85 %. Die zweite Stufe, die Einführung von X erfolgte darauf in einer Ausbeute von 48 %.

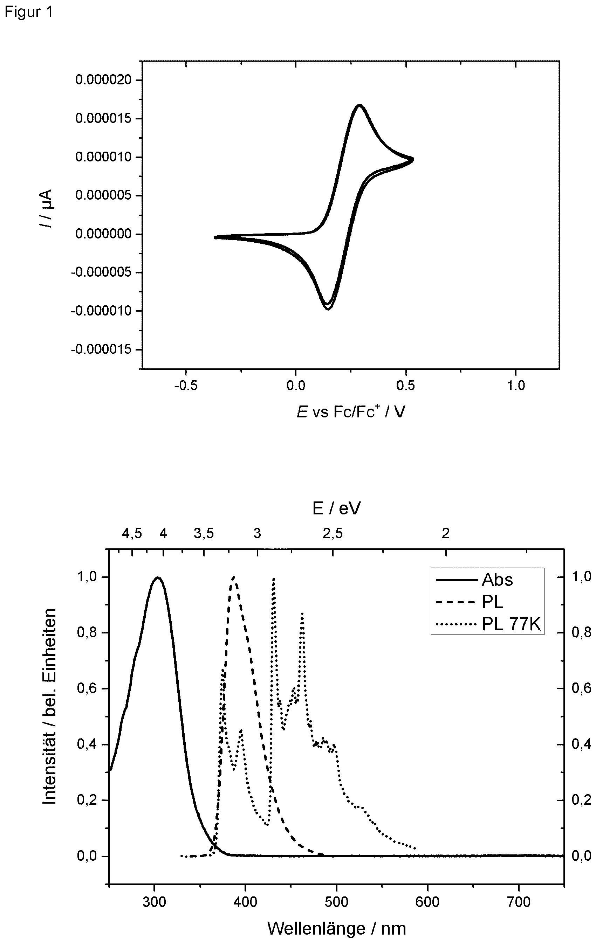

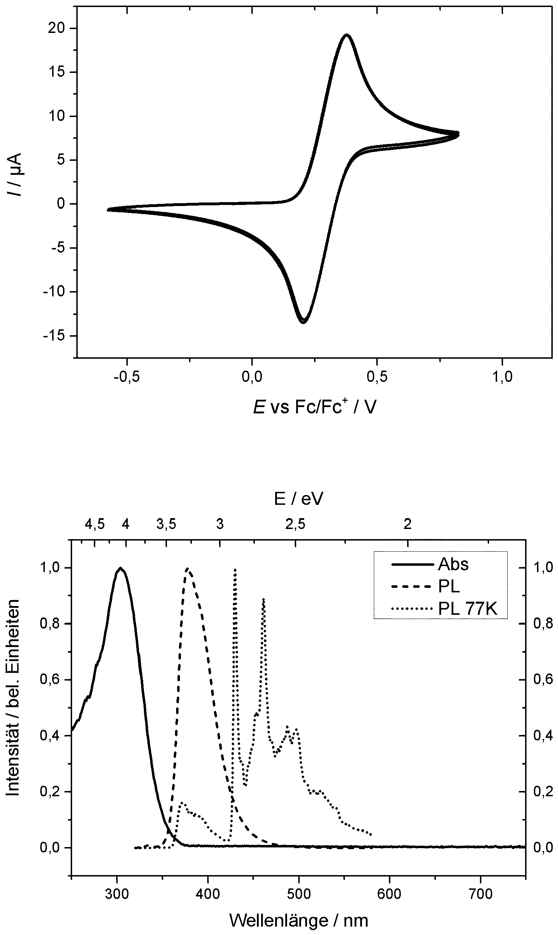

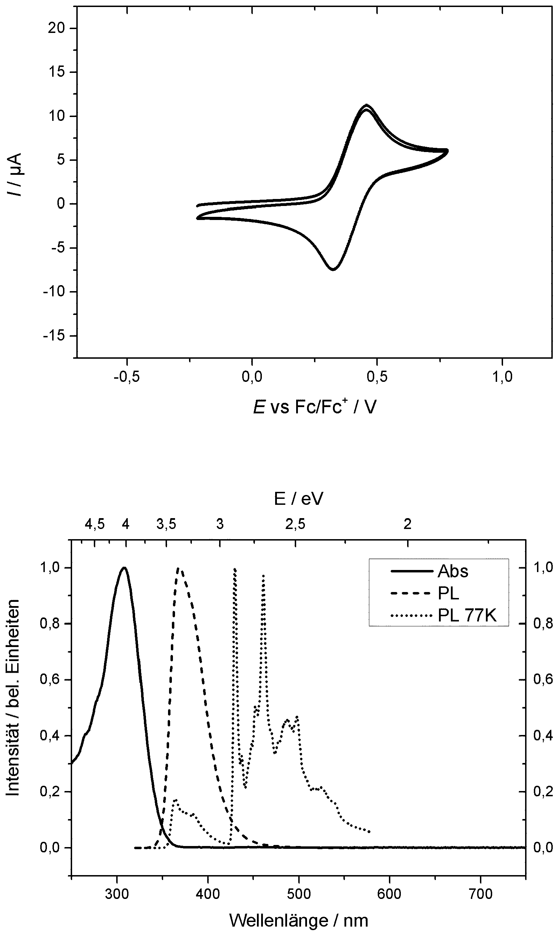

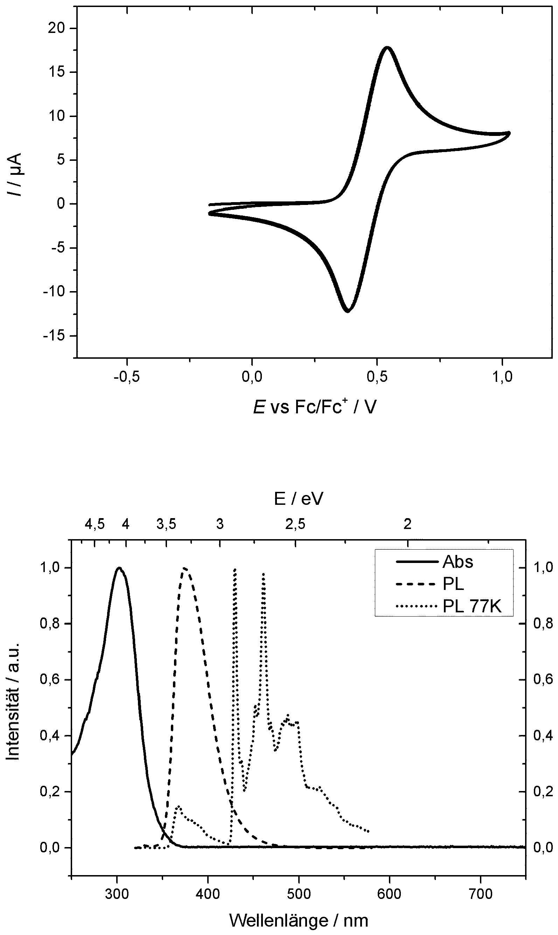

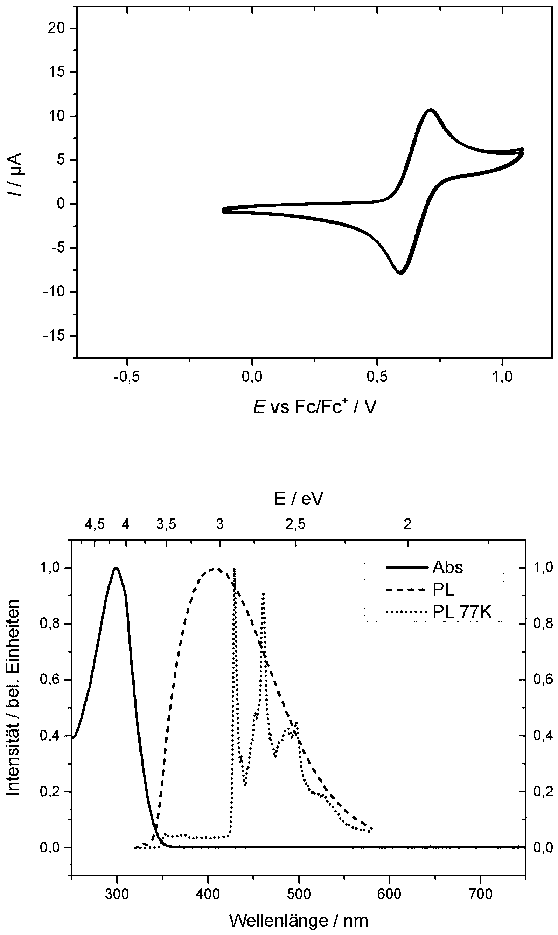

In den Figuren 1 bis 5 sind die elektrochemischen sowie photophysikalischen Messergebnisse für die Moleküle 1 bis 5 dargestellt.

Nachfolgend werden die aus den elektrochemischen sowie photophysikalischen Messungen extrahierten Werte tabellarisch aufgeführt:

**Tab 1: Es werden das Oxidationspotential gegen Ferrocene gemessen in Volt (E_{Ox} vs Fc / V), die bathochrome Absorptionskante in Nanometer (Abs Icutoff / nm), das Absorptionsmaximum in Nanometer (Abs Imax / nm), die errechnete HOMO Energie in Elektronenvolt (E_{HOMO} / eV), die errechnete LUMO Energie in Elektronenvolt (E_{LUMO} / eV), der S1-Zustand in Elektronenvolt aus der Photolumineszenz bei maximaler Intensität (PLₘₐₓ S1 / eV), der T1-Zustand in Elektronenvolt aus der tieftemperatur Photolumineszenz bei maximaler Intensität (PLₘₐₓ T1 / eV), die Energiedifferenz zwischen S1 und T1 Zustand aus der Photolumineszenz bei maximaler Intensität (DE_{ST, max} / eV).**

| Material | E_{Ox} vs Fc / V | Abs I_{cutoff} / nm | Abs Iₘₐₓ / nm | E_{HOMO} / eV | E_{LUMO} / eV | PLₘₐₓ S₁ / eV | PLₘₐₓ T₁ / eV | DE_{ST} / eV |
|---|---|---|---|---|---|---|---|---|
| **1** | 0.21 | 348 | 303 | -5.31 | -1.74 | 3.20 | 2.9 | 0.30 |
| **2** | 0.29 | 348 | 304 | -5.39 | -1.82 | 3.28 | 2.9 | 0.38 |
| **3** | 0.39 | 345 | 309 | -5.49 | -1.90 | 3.38 | 2.9 | 0.48 |
| **4** | 0.46 | 339 | 302 | -5.56 | -1.90 | 3.31 | 2.9 | 0.41 |
| **5** | 0.65 | 337 | 298 | -5.75 | -2.07 | 3.01 | 2.9 | 0.11 |

### Figuren

Es zeigen:
Figur 1: Cyclovoltammogramm (oben) sowie Absorptions- und Emissionsspektren (unten; Intensität über Wellenlänge) für Molekül 1;
Figur 2: Cyclovoltammogramm (oben) sowie Absorptions- und Emissionsspektren (unten; Intensität über Wellenlänge) für Molekül 2;
Figur 3: Cyclovoltammogramm (oben) sowie Absorptions- und Emissionsspektren (unten; Intensität über Wellenlänge) für Molekül 3;
Figur 4: Cyclovoltammogramm (oben) sowie Absorptions- und Emissionsspektren (unten; Intensität über Wellenlänge) für Molekül 4;
Figur 5: Cyclovoltammogramm (oben) sowie Absorptions- und Emissionsspektren (unten; Intensität über Wellenlänge) für Molekül 5.

## Patentansprüche

1. Organisches Molekül, aufweisend eine Struktur der Formel 1 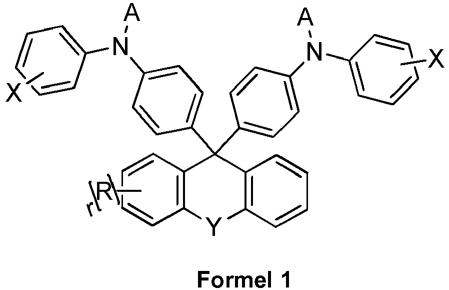 mit 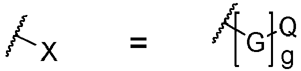 wobei
Y = eine kovalente Einfachbindung oder eine bivalente Brücke ausgewählt aus O, S, S=O, SO₂, Se, Se=O, SeO₂, C(R³)₂, C=NR³, C=C(R³)₂, Si(R³)₂, N(R³), P(R³), P(=O)R³ oder B(R³);
r = 0 bis 8;
R = bei jedem Auftreten gleich oder verschieden Wasserstoff, Deuterium, Halogen, eine Alkylgruppe (unverzweigt, verzweigt oder zyklisch), eine Alkoxygruppe (unverzweigt, verzweigt oder zyklisch), eine Alkenylgruppe (unverzweigt, verzweigt oder zyklisch), oder eine Aryl- oder Heteroarylgruppe mit 5 bis 40 Ringatomen, die jeweils durch einen oder mehrere Reste R⁴ substituiert sein kann, oder ein aromatisches oder heteroaromatisches Ringsystem mit 5 bis 60 aromatischen Ringatomen, das jeweils durch einen oder mehrere Reste R⁴ substituiert sein kann, oder eine Aryloxy- oder Heteroaryloxygruppe mit 5 bis 40 aromatischen Ringatomen, die durch einen oder mehrere R⁴ substituiert sein kann, oder eine Aralkyl- oder Heteroaralkylgruppe mit 5 bis 40 aromatischen Ringatomen, die durch einen oder mehrere R⁴ substituiert sein kann, oder eine Kombination dieser Systeme; dabei können zwei oder mehrere Substituenten R auch miteinander, zusammen mit den Atomen, an die sie gebunden sind, ein mono- oder polycylisches aliphatisches Ringsystem bilden;
R³ ist bei jedem Auftreten gleich oder verschieden H, D, OR⁵, SR⁵ oder C(R⁵)₃;
R⁴ ist bei jedem Auftreten gleich oder verschieden H, D, OR⁵, SR⁵ oder C(R⁵)₃;
R⁵ ist bei jedem Auftreten gleich oder verschieden Wasserstoff, eine Alkylgruppe oder eine Arylgruppe;
g = 3 bis 10;
G = bei jedem Auftreten gleich oder verschieden Sauerstoff, eine Alkylgruppe (unverzweigt, verzweigt oder zyklisch), eine Alkoxygruppe (unverzweigt, verzweigt oder zyklisch), eine Alkenylgruppe (unverzweigt, verzweigt oder zyklisch), oder eine Aryl- oder Heteroarylgruppe mit 5 bis 40 Ringatomen, die jeweils durch einen oder mehrere Reste R⁴ substituiert sein kann, oder ein aromatisches oder heteroaromatisches Ringsystem mit 5 bis 60 aromatischen Ringatomen, das jeweils durch einen oder mehrere Reste R⁴ substituiert sein kann, oder eine Aryloxy- oder Heteroaryloxygruppe mit 5 bis 40 aromatischen Ringatomen, die durch einen oder mehrere R⁴ substituiert sein kann, oder eine Aralkyl- oder Heteroaralkylgruppe mit 5 bis 40 aromatischen Ringatomen, die durch einen oder mehrere R⁴ substituiert sein kann, oder eine Kombination dieser Systeme;
Q = photochemisch oder thermisch vernetzbaren Gruppe;
A = Steuerrest gemäß Unterformel 2 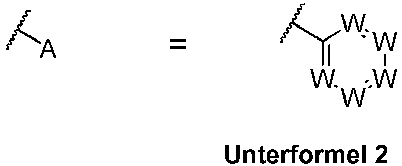 mit
W = Ringglieder unabhängig voneinander ausgewählt aus N, C-H, C-Ak oder C-Do;
Ak = Akzeptorgruppe; und
Do = Donorgruppe.

2. Organisches Molekül nach Anspruch 1, wobei g 3 bis 9, insbesondere 5 bis 9, insbesondere 6 bis 8 ist.

3. Organischen Molekül nach Anspruch 1 oder 2, wobei die photochemisch oder thermisch vernetzbaren Gruppe Q ausgewählt ist aus der Gruppe bestehend aus 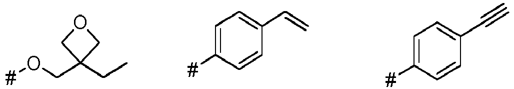 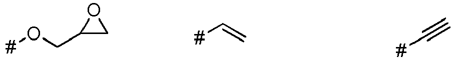 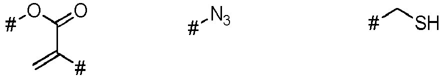 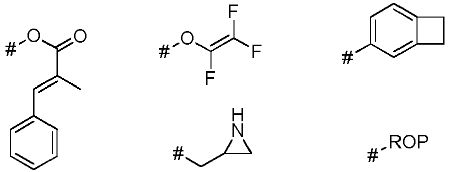 und wobei die Anknüpfung an die Kette (G)g über den # erfolgt.

4. Organisches Molekül nach Anspruch 1 bis 3, wobei die Akzeptorgruppe Ak ausgewählt ist aus der Gruppe bestehend aus -(C=O)R, -F, -CF3, CN und/ oder die Donorgruppe Do ausgewählt ist aus der Gruppe bestehend aus -OR, -NR2, -CR3, wobei R wie in Anspruch 1 definiert ist.

5. Organisches Molekül nach Anspruch 1 bis 4, wobei Y eine kovalente Einfachbindung ist.

6. Organisches Molekül nach Anspruch 1 bis 5, wobei r = 0 ist.

7. Organisches Molekül nach Anspruch1 bis 6, wobei maximal drei der Ringglieder W ungleich C-H sind.

8. Organisches Molekül nach Anspruch 1 bis 7, wobei unter den Kettengliedern G genau 1 oder 2 Sauerstoffatome sind.

9. Organisches Molekül nach Anspruch 1 bis 8, wobei die Kettenglieder G ausschließlich unverzweigte Reste sind.

10. Organisches Molekül nach Anspruch 1 bis 9, wobei die Ringglieder W ausschließlich C-H, C-Ak und/oder C-Do sind.

11. Organisches Molekül nach Anspruch 1 bis 2 oder 4 bis 10 wobei die Gruppe Q ausgewählt ist aus der Gruppe der Oxetane der Unterformeln 3 oder 4: 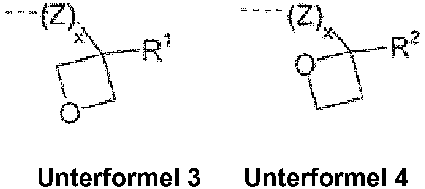 wobei für die verwendeten Symbole und Indizes gilt:
R¹ ist bei jedem Auftreten gleich oder verschieden H, eine geradkettige, verzweigte oder cyclische Alkyl-, Alkoxyalkyl-, Alkoxy- oder Thioalkoxy-Gruppe mit 1 bis 20 C-Atomen, eine Aryl- oder Heteroaryl-Gruppe mit 4 bis 20 aromatischen Ringatomen oder eine Alkenylgruppe mit 2 bis 10 C-Atomen, bei denen ein oder mehrere Wasserstoffatome durch Halogen oder CN ersetzt sein können und ein oder mehrere nicht benachbarte C-Atome durch -O-, -S-, -CO-, -COO- oder -O-CO- ersetzt sein können;
R² ist bei jedem Auftreten gleich oder verschieden H, eine geradkettige, verzweigte oder cyclische Alkyl- oder Alkoxyalkylgruppe mit 1 bis 20 C-Atomen, eine Aryl- oder Heteroaryl-Gruppe mit 4 bis 20 aromatischen Ringatomen oder eine Alkenylgruppe mit 2 bis 10 C-Atomen, bei denen ein oder mehrere Wasserstoffatome durch Halogen oder CN ersetzt sein können und ein oder mehrere nicht benachbarte C-Atome durch -O-, -S-, -CO-, -COO- oder -O-CO- ersetzt sein können;
Z ist bei jedem Auftreten gleich oder verschieden eine bivalente Gruppe - (CR⁶R⁷)ₙ-, bei der auch ein oder mehrere nicht benachbarte C-Atome durch - O-, -S-, -CO-, -COO- oder -O-CO- ersetzt sein können, oder eine bivalente Aryl- oder N-, S- und/oder O-Heteroarylgruppe mit 4 bis 40 C-Atomen, die auch mit ein oder mehreren Resten R⁶ substituiert sein kann; R⁶, R⁷ ist bei jedem Auftreten gleich oder verschieden H, eine geradkettige, verzweigte oder cyclische Alkyl-, Alkoxy-, Alkoxyalkyl- oder Thioalkoxy- Gruppe mit 1 bis 20 C-Atomen, eine Aryl- oder Heteroaryl-Gruppe mit 4 bis 20 aromatischen Ringatomen oder eine Alkenyl-Gruppe mit 2 bis 10 C- Atomen, bei denen ein oder mehrere Wasserstoffatome auch durch Halogen oder CN ersetzt sein können;
dabei können auch Reste R⁶ bzw. R⁷ miteinander bzw. mit R¹ oder R² ein Ringsystem bilden;
n ist bei jedem Auftreten gleich oder verschieden eine ganze Zahl zwischen 0 und 30, vorzugsweise zwischen 1 und 20, insbesondere zwischen 2 und 12,
x ist bei jedem Auftreten gleich oder verschieden 0, 1, 2, 3, 4 oder 5, insbesondere 1, 2 oder 3,
wobei die gestrichelte Bindung die Anknüpfungsstelle an die Gruppe (G)g anzeigt.

12. Organisches Molekül nach Anspruch 1 bis 11, wobei in den Gruppen C-Do und C-Ak ausschließlich eine Art von Do beziehungsweise Ak vorhanden ist.

13. Verwendung eines Organischen Moleküls nach Anspruch 1 bis 12 in einem optoelektronischen Bauelement.

14. Verwendung nach Anspruch 13, wobei das organische Molekül in einer emittierenden Schicht, insbesondere als Matrixmaterial, insbesondere für lumineszierende Emitter und/oder als Elektronentransportmaterial und/oder als Lochinjektionsmaterial und/oder als Lochblockiermaterial verwendet wird.

15. Verwendung nach Anspruch 13 oder 14, wobei das optoelektronische Bauelement ausgewählt ist aus der Gruppe bestehend aus:
- Organischen Licht-emittierenden Bauteilen (OLEDs),
- Licht-emittierenden elektrochemischen Zellen,
- OLED-Sensoren, insbesondere in nicht hermetisch nach außen abgeschirmten Gas- und Dampf-Sensoren,
- organischen Solarzellen,
- Organischen Feldeffekttransistoren,
- Organischen Lasern und
- Down-Konversions-Elementen.
- Up-Konversions-Elementen.

16. Optoelektronisches Bauelement, aufweisend ein Organisches Molekül nach Anspruch 1 bis 12.

17. Optoelektronisches Bauelement nach Anspruch 16, wobei das Organische Molekül in einer emittierenden Schicht eingesetzt ist, bevorzugt als Matrixmaterial insbesondere für lumineszierende Emitter und/oder Elektronentransportmaterial und/oder als Lochinjektionsmaterial und/oder als Lochblockiermaterial.

18. Mischung, aufweisend mindestens ein organisches Molekül nach Anspruch 1 bis 12 und mindestens einen lumineszierenden Emitter.

19. Verfahren zur Herstellung eines optoelektronischen Bauelements, wobei ein Organisches Molekül nach Anspruch 1 bis 12 verwendet wird.

## Claims

1. An organic molecule comprising a structure of formula 1 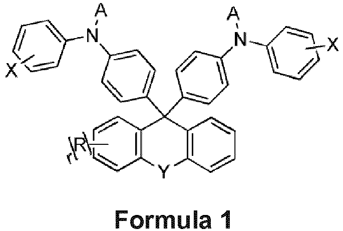 with 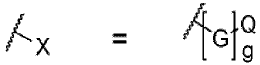 wherein
Y = a covalent single bond or a bivalent bridge selected from O, S, S=O, SO₂, Se, Se=O, SeO₂, C(R³)₂, C=NR³, C=C(R³)₂, Si(R³)₂, N(R³), P(R³), P(=O)R³, or B(R³);
r = 0 to 8;
R = identically or differently at each occurrence, hydrogen, deuterium, halogen, an alkyl group (unbranched, branched or cyclic), an alkoxy group (unbranched, branched or cyclic), an alkenyl group (unbranched, branched or cyclic), or an aryl group or heteroaryl group having 5 to 40 ring atoms, which groups in each case be substituted by one or more groups R⁴, or an aromatic or heteroaromatic ring system having 5 to 60 aromatic ring atoms, which ring system in each case may be substituted by one or more groups R⁴, or an aryloxy group or heteroaryloxy group having 5 to 40 aromatic ring atoms, which groups in each case may be substituted by one or more R⁴, or an aralkyl group or heteroaralkyl group having 5 to 40 aromatic ring atoms, which groups in each case may be substituted by one or more R⁴, or a combination of these systems; two or more substituents R may also form a mono- or polycyclic aliphatic ring system with each other, together with the atoms to which said substituents R are bonded;
R³, identically or differently at each occurrence, is H, D, OR⁵, SR⁵ or C(R⁵)₃;
R^{4,} identically or differently at each occurrence, is H, D, OR⁵, SR⁵ or C(R⁵)₃;
R⁵, identically or differently at each occurrence, is hydrogen, an alkyl group or an aryl group;
g = 3 to 10;
G = identically or differently at each occurrence, oxygen, an alkyl group (unbranched, branched or cyclic), an alkoxy group (unbranched, branched or cyclic), an alkenyl group (unbranched, branched or cyclic), or an aryl group or heteroaryl group having 5 to 40 ring atoms, which groups in each case may be substituted by one or more groups R⁴, or an aromatic or heteroaromatic ring system having 5 to 60 aromatic ring atoms, which systems in each case may be substituted by one or more groups R⁴, or an aryloxy group or heteroaryloxy group having 5 to 40 aromatic ring atoms, which groups in each case may be substituted by one or more R⁴, or an aralkyl group or heteroaralkyl group having 5 to 40 aromatic ring atoms, which groups in each case may be substituted by one or more R⁴, or a combination of these systems;
Q = photochemically or thermally cross-linkable group;
A = control group according to sub-formula 2 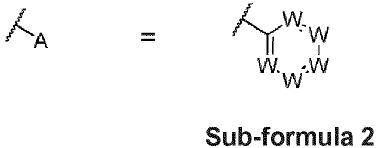 with
W = ring members selected independently of one another from N, C-H, C-Ak or C-Do;
Ak = acceptor group; and
Do = donor group.

2. The organic molecule according to claim 1, wherein g is 3 to 9, especially 5 to 9, especially 6 to 8.

3. The organic molecule according to claim 1 or claim 2, wherein the photochemically or thermally cross-linkable group Q is selected from the group consisting of 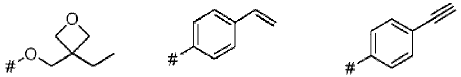 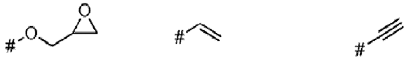 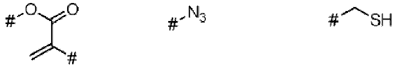 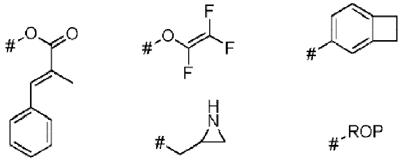 and wherein the linking to the chain (G)g is implemented by means of the # link.

4. The organic molecule according to claims 1 to 3, wherein the acceptor group Ak is selected from the group consisting of -(C=O)R, -F, - CF3, CN and/or the donor group Do is selected from the group consisting of -OR, -NR2, -CR3, with R being as defined in claim 1.

5. The organic molecule according to claims 1 to 4, wherein Y is a single covalent bond.

6. The organic molecule according to claims 1 to 5, wherein r = 0.

7. The organic molecule according to claims 1 to 6, wherein at most three of the ring members W are not C-H.

8. The organic molecule according to claims 1 to 7, wherein precisely 1 or 2 of the chain members G are oxygen atoms.

9. The organic molecule according to claims 1 to 8, wherein the chain members G are exclusively unbranched groups.

10. The organic molecule according to claims 1 to 9, wherein the ring members W are exclusively C-H, C-Ak and/or C-Do.

11. The organic molecule according to claims 1 to 2 or 4 to 10, wherein the group Q is selected from the group of oxetanes of sub-formulas 3 or 4: 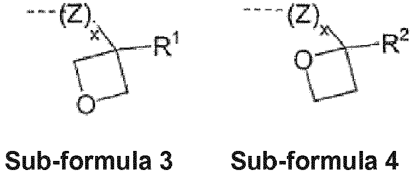 wherein the following applies for the used symbols and indices:
R¹ is, identically or differently at each occurrence, H, a straight-chain, branched or cyclic alkyl, alkoxyalkyl, alkoxy, or thioalkoxy group having 1 to 20 C atoms, an aryl or heteroaryl group having 4 to 20 aromatic ring atoms, or an alkenyl group having 2 to 10 C atoms, wherein one or more hydrogen atoms may be replaced by halogen or CN and one or more non-adjacent C atoms may be replaced by -O-, -S-, -CO-, -COO- or -O-CO-;
R², identically or differently at each occurrence, is H, a straight-chain, branched or cyclic alkyl or alkoxyalkyl group having 1 to 20 C atoms, an aryl or heteroaryl group having 4 to 20 aromatic ring atoms, or an alkenyl group having 2 to 10 C atoms, wherein one or more hydrogen atoms may be replaced by halogen or CN and one or more non-adjacent C atoms may be replaced by -O-, -S-, -CO-, -COO- or -O-CO-;
Z, identically or differently at each occurrence, is a bivalent group -(CR⁶R⁷)ₙ-, wherein one or more non-adjacent C atoms also may be replaced by -O-, -S-, -CO-, -COO- or -O-CO-, or a bivalent aryl- or N-, S- and/or O-heteroaryl group having 4 to 40 C atoms, which group also may be substituted with one or more groups R⁶; R⁶, R⁷, identically or differently at each occurrence, is H, a straight-chain, branched or cyclic alkyl, alkoxy, alkoxyalkyl or thioalkoxy group having 1 to 20 C atoms, an aryl or heteroaryl group having 4 to 20 aromatic ring atoms, or an alkenyl group having 2 to 10 C atoms, wherein one or more hydrogen atoms also may be replaced by halogen or CN;
groups R⁶ and R⁷ may also form a ring system with one another or with R¹ or R²;
n, identically or differently at each occurrence, is an integer between 0 and 30, preferably between 1 and 20, in particular between 2 and 12,
x, identically or differently at each occurrence, is 0, 1, 2, 3, 4 or 5, in particular 1, 2 or 3,
wherein the dashed bond indicates the connection point to the group (G)g.

12. The organic molecule according to claims 1 to 11, wherein exclusively one type of Do or Ak is provided in the groups C-Do and C-Ak.

13. Use of an organic molecule according to claims 1 to 12 in an optoelectronic component.

14. Use according to claim 13, wherein the organic molecule is used in an emitting layer, in particular as matrix material, in particular for luminescent emitters and/or as electron transport material and/or as hole injection material and/or as hole blocking material.

15. Use according to claim 13 or claim 14, wherein the optoelectronic component is selected from the group consisting of:
- organic light-emitting components (OLEDs),
- light-emitting electrochemical cells,
- OLED sensors, in particular in non-hermetically outwardly shielded gas and vapour sensors,
- organic solar cells,
- organic field-effect transistors,
- organic lasers, and
- down-conversion elements,
- up-conversion elements.

16. An optoelectronic component, comprising an organic molecule according to claim 1 to 12.

17. The optoelectronic component according to claim 16, wherein the organic molecule is used in an emitting layer, preferably as matrix material in particular for luminescent emitters and/or electron transport material and/or as hole injection material and/or as hole blocking material.

18. A mixture, comprising at least one organic molecule according to claims 1 to 12 and at least one luminescent emitter.

19. A method for producing an optoelectronic component, wherein an organic molecule according to claims 1 to 12 is used.

## Revendications

1. Molécule organique, comprenant une structure de la formule 1 : 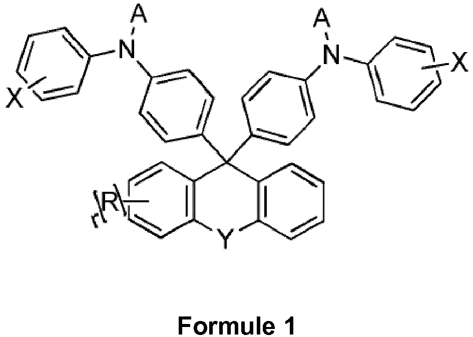 avec 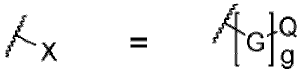 dans laquelle
Y = une simple liaison covalente ou un pont bivalent choisi parmi O, S, S=O, SO₂, Se, Se=O, SeO₂, C(R³)₂, C=NR³, C=C(R³)₂, Si(R³)₂, N(R³), P(R³), P(=O)R³ ou B(R³) ;
r = 0 à 8 ;
les R = à chaque occurrence, de manière identique ou différente, hydrogène, deutérium, halogène, un groupe alkyle (non ramifié, ramifié ou cyclique), un groupe alcoxy (non ramifié, ramifié ou cyclique), un groupe alcényle (non ramifié, ramifié ou cyclique) ou un groupe aryle ou hétéroaryle contenant 5 à 40 atomes de cycle, qui peut à chaque fois être substitué par un ou plusieurs radicaux R⁴, ou un système cyclique aromatique ou hétéroaromatique contenant 5 à 60 atomes de cycle aromatique, qui peut à chaque fois être substitué par un ou plusieurs radicaux R⁴, ou un groupe aryloxy ou hétéroaryloxy contenant 5 à 40 atomes de cycle aromatique, qui peut être substitué par un ou plusieurs R⁴, ou un groupe aralkyle ou hétéroaralkyle contenant 5 à 40 atomes de cycle aromatique, qui peut être substitué par un ou plusieurs R⁴, ou une combinaison de ces systèmes ; deux substituants R ou plus pouvant également former les uns avec les autres, conjointement avec les atomes auxquels ils sont reliés, un système cyclique aliphatique mono- ou polycyclique ;
les R³ représentent à chaque occurrence, de manière identique ou différente, H, D, OR⁵, SR⁵ ou C(R⁵)₃;
les R⁴ représentent à chaque occurrence, de manière identique ou différente, H, D, OR⁵, SR⁵ ou C(R⁵)₃;
les R⁵ représentent à chaque occurrence, de manière identique ou différente, l'hydrogène, un groupe alkyle ou un groupe aryle ;
g = 3 à 10 ;
les G = à chaque occurrence, de manière identique ou différente, l'oxygène, un groupe alkyle (non ramifié, ramifié ou cyclique), un groupe alcoxy (non ramifié, ramifié ou cyclique), un groupe alcényle (non ramifié, ramifié ou cyclique) ou un groupe aryle ou hétéroaryle contenant 5 à 40 atomes de cycle, qui peut à chaque fois être substitué par un ou plusieurs radicaux R⁴, ou un système cyclique aromatique ou hétéroaromatique contenant 5 à 60 atomes de cycle aromatiques, qui peut à chaque fois être substitué par un ou plusieurs radicaux R⁴, ou un groupe aryloxy ou hétéroaryloxy contenant 5 à 40 atomes de cycle aromatique, qui peut être substitué par un ou plusieurs R⁴, ou un groupe aralkyle ou hétéroaralkyle contenant 5 à 40 atomes de cycle aromatique, qui peut être substitué par un ou plusieurs R⁴, ou une combinaison de ces systèmes ;
Q = groupe réticulable photochimiquement ou thermiquement ;
A = radical de régulation selon la sous-formule 2 : 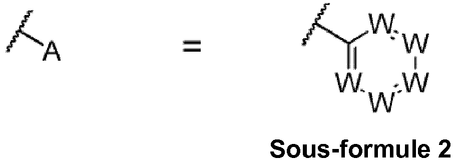 avec
les W = chaînons choisis indépendamment les uns des autres parmi N, C-H, C-Ak ou C-Do ;
Ak = groupe accepteur ; et
Do = groupe donneur.

2. Molécule organique selon la revendication 1, dans laquelle g représente 3 à 9, notamment 5 à 9, notamment 6 à 8.

3. Molécule organique selon la revendication 1 ou 2, dans laquelle le groupe Q réticulable photochimiquement ou thermiquement est choisi dans le groupe constitué par : 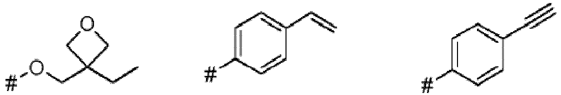 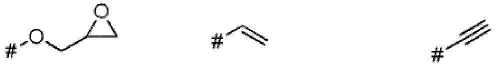 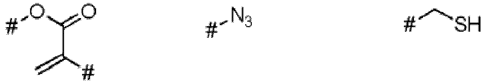 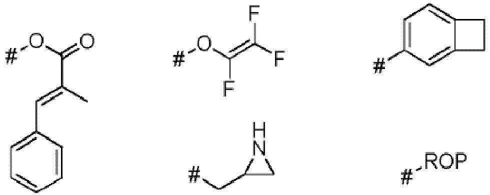 et dans laquelle la liaison à la chaîne (G)g a lieu par #.

4. Molécule organique selon les revendications 1 à 3, dans laquelle le groupe accepteur Ak est choisi dans le groupe constitué par -(C=O)R, -F, - CF₃, CN et/ou le groupe donneur Do est choisi dans le groupe constitué par -OR, -NR₂, -CR₃, R étant tel que défini dans la revendication 1.

5. Molécule organique selon les revendications 1 à 4, dans laquelle Y est une simple liaison covalente.

6. Molécule organique selon les revendications 1 à 5, dans laquelle r = 0.

7. Molécule organique selon les revendications 1 à 6, dans laquelle au plus trois des chaînons W sont différents de C-H.

8. Molécule organique selon les revendications 1 à 7, dans laquelle, parmi les chaînons G, exactement 1 ou 2 sont des atomes d'oxygène.

9. Molécule organique selon les revendications 1 à 8, dans laquelle les chaînons G sont exclusivement des radicaux non ramifiés.

10. Molécule organique selon les revendications 1 à 9, dans laquelle les chaînons W sont exclusivement C-H, C-Ak et/ou C-Do.

11. Molécule organique selon les revendications 1 à 2 ou 4 à 10, dans laquelle le groupe Q est choisi dans le groupe des oxétanes des sous-formules 3 ou 4 : 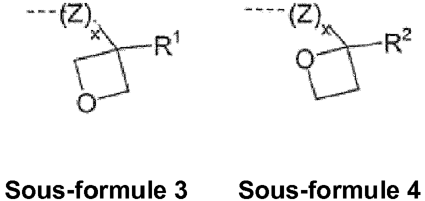 dans lesquelles, pour les symboles et les indices utilisés :
les R¹ représentent à chaque occurrence, de manière identique ou différente, H, un groupe alkyle, alcoxyalkyle, alcoxy ou thioalcoxy linéaire, ramifié ou cyclique, contenant 1 à 20 atomes C, un groupe aryle ou hétéroaryle contenant 4 à 20 atomes de cycle aromatique, ou un groupe alcényle contenant 2 à 10 atomes C, dans lesquels un ou plusieurs atomes d'hydrogène peuvent être remplacés par halogène ou CN, et un ou plusieurs atomes C non voisins peuvent être remplacés par -O-, -S-, -CO-, -COO- ou -O-CO- ;
les R² représentent à chaque occurrence, de manière identique ou différente, H, un groupe alkyle ou alcoxyalkyle linéaire, ramifié ou cyclique contenant 1 à 20 atomes C, un groupe aryle ou hétéroaryle contenant 4 à 20 atomes de cycle aromatique, ou un groupe alcényle contenant 2 à 10 atomes C, dans lesquels un ou plusieurs atomes d'hydrogène peuvent être remplacés par halogène ou CN, et un ou plusieurs atomes C non voisins peuvent être remplacés par -O-, -S-, -CO-, -COO- ou -O-CO- ;
les Z représentent à chaque occurrence, de manière identique ou différente, un groupe bivalent -(CR⁶R⁷)ₙ-, dans lequel un ou plusieurs atomes C non voisins peuvent également être remplacés par -O-, -S-, - CO-, -COO- ou -O-CO-, ou un groupe aryle ou N-, S- et/ou O-hétéroaryle bivalent contenant 4 à 40 atomes C, qui peut également être substitué avec un ou plusieurs radicaux R⁶; R⁶, R⁷ représentant à chaque occurrence de manière identique ou différente H, un groupe alkyle, alcoxy, alcoxyalkyle ou thioalcoxy linéaire, ramifié ou cyclique contenant 1 à 20 atomes C, un groupe aryle ou hétéroaryle contenant 4 à 20 atomes de cycle aromatique, ou un groupe alcényle contenant 2 à 10 atomes C, dans lesquels un ou plusieurs atomes d'hydrogène peuvent également être remplacés par halogène ou CN ;
les radicaux R⁶ et R⁷ pouvant également former un système cyclique les uns avec les autres ou avec R¹ ou R² ;
les n représentent à chaque occurrence de manière identique ou différente un nombre entier compris entre 0 et 30, de préférence entre 1 et 20, notamment entre 2 et 12,
les x représentent à chaque occurrence de manière identique ou différente 0, 1, 2, 3, 4 ou 5, notamment 1, 2 ou 3,
la liaison en pointillés indiquant l'emplacement de liaison au groupe (G)g.

12. Molécule organique selon les revendications 1 à 11, dans laquelle exclusivement un type de Do ou Ak est présent dans les groupes C-Do et C-Ak.

13. Utilisation d'une molécule organique selon les revendications 1 à 12 dans un composant optoélectronique.

14. Utilisation selon la revendication 13, dans laquelle la molécule organique est utilisée dans une couche d'émission, notamment en tant que matériau de matrice, notamment pour des émetteurs luminescents, et/ou en tant que matériau de transport d'électrons et/ou en tant que matériau d'injection de trous et/ou en tant que matériau de blocage de trous.

15. Utilisation selon la revendication 13 ou 14, dans laquelle le composant optoélectronique est choisi dans le groupe constitué par :
- les composants organiques électroluminescents (OLED),
- les cellules électrochimiques électroluminescentes,
- les capteurs OLED, notamment dans des capteurs de gaz et de vapeur non blindés hermétiquement vers l'extérieur,
- les cellules solaires organiques,
- les transistors à effet de champ organiques,
- les lasers organiques et
- les éléments de conversion à la baisse,
- les éléments de conversion à la hausse.

16. Composant optoélectronique, comprenant une molécule organique selon les revendications 1 à 12.

17. Composant optoélectronique selon la revendication 16, dans lequel la molécule organique est utilisée dans une couche d'émission, de préférence en tant que matériau de matrice, notamment pour des émetteurs luminescents et/ou en tant que matériau de transport d'électrons et/ou en tant que matériau d'injection de trous et/ou en tant que matériau de blocage de trous.

18. Mélange, comprenant au moins une molécule organique selon les revendications 1 à 12 et au moins un émetteur luminescent.

19. Procédé de fabrication d'un composant optoélectronique, dans lequel une molécule organique selon les revendications 1 à 12 est utilisée.
